# EUROPÄISCHE PATENTANMELDUNG

(11) **EP 2 107 131 A1**
(43) Veröffentlichungstag der Anmeldung: **07.10.2009**
(21) Anmeldenummer: 09155381.8
(22) Anmeldetag: 17.03.2009
(51) Int. Cl.: C23C 4/12, C23C 16/513, C23C 4/02

(54) **Verfahren und Anlage zum Beschichten und zur Oberflächenbehandlung von Substraten mittels eines Plasmastrahls**

(30) Priorität: 04.04.2008 EP 08154091
(71) Anmelder: Sulzer Metco AG (Switzerland), 5610 Wohlen (CH)
(72) Erfinder: Refke, Arno, Dr., 5615 Fahrwangen (CH); Hollenstein, Christoph, Dr., 1095 Lutry (CH)
(74) Vertreter: Sulzer Management AG

(57) **Zusammenfassung**

Zum Beschichten und zur Oberflächenbehandlung von Substraten mittels eines Plasmastrahls wird eine Arbeitskammer (2) mit einem Plasmabrenner (4) zur Verfügung gestellt, ein Plasmastrahl (5) erzeugt, indem ein Plasmagas durch den Plasmabrenner geleitet und in demselben mittels elektrischer Gasentladung, elektromagnetischer Induktion oder Mikrowellen aufgeheizt wird, und der Plasmastrahl auf ein in die Arbeitskammer (2) eingebrachtes Substrat (3) gelenkt, wobei der zur Verfügung gestellte Plasmabrenner (4) eine Leistung zum thermischen Plasmaspritzen von Feststoffpartikeln hat. Während des Beschichtens beziehungsweise der Oberflächenbehandlung beträgt der Druck in der Arbeitskammer (2) zwischen 0.01 und 10 mbar, und es wird zusätzlich mindestens eine reaktive Komponente in flüssiger oder gasförmiger Form in den Plasmastrahl injiziert, um eine Oberfläche des Substrats (3) zu beschichten oder zu behandeln.

## Beschreibung

Die Erfindung betrifft ein Verfahren zum Beschichten und/oder zur Oberflächenbehandlung von Substraten mittels eines Plasmastrahls gemäss Oberbegriff von Anspruch 1, ein Substrat, hergestellt mit einem derartigen Verfahren, und eine Plasmabeschichtungsanlage gemäss Oberbegriff von Anspruch 11 zur Durchführung eines derartigen Verfahrens.

Beschichtungsgeräte wie beispielsweise Vakuumaufdampfanlagen, Sputteranlagen, Anlagen für Chemical Vapour Deposition und thermische Spritzgeräte wie zum Beispiel thermische Plasmaspritzgeräte werden heute in vielen Bereichen der industriellen Fertigung verwendet, um Substrate zu beschichten. Typische Substrate umfassen zum Beispiel Werkstücke mit gekrümmten Oberflächen wie beispielsweise Werkzeuge oder Zylinderlaufflächen von Verbrennungsmotoren, eine Vielzahl von Bauteilen und Halbfabrikaten, auf denen mittels eines thermischen Spritzverfahrens zum Beispiel ein Korrosionsschutz aufgebracht wird, aber auch im Wesentlichen ebene Substrate wie Wafer und Folien, auf die eine Beschichtung aufgebracht wird, beispielsweise leitende oder isolierende Schichten für Halbleiter wie zum Beispiel Solarzellen. Die aufgebrachten Schichten können beispielsweise dazu verwendet werden, die Oberfläche widerstandsfähig gegen mechanische und/oder chemische und insbesondere korrosive Einflüsse zu machen, die Reibung und/oder Haftung auf der Oberfläche zu reduzieren, die Oberfläche elektrisch und/oder thermisch isolierend oder fallweise leitend zu machen, die Oberfläche für Lebensmittel geeignet und/oder für Blut oder Gewebe verträglich zu machen, und/oder Abdichtungen und Diffusionssperren zu bilden, um nur einige typische Anwendungen zu nennen.

Zur reaktiven Behandlung von Oberflächen und zur reaktiven Abscheidung dünner Schichten mittels eines Plasmas wurden Anlagen mit einer Plasmaquelle entwickelt. Die entsprechenden Verfahren sind unter der Bezeichnung Plasmaoberflächenbehandlung, Plasmaätzen, Plasmabeschichten oder Plasma enhanced Chemical Vapour Deposition (Plasma enhanced CVD) bekannt. Eine Anlage für derartige Verfahren ist in Dokument EP 0 297 637 A1 beschrieben. Die ebenda beschriebene Anlage umfasst eine Kammer mit einem Plasmabrenner von bis zu 1 kW Leistung und eine evakuierbare Behandlungskammer, die das zu behandelnde Substrat enthält. Das reaktive Behandlungsmittel wird dem Plasmabrenner in gasförmiger oder flüssiger Form zugeführt. Der Druck in der Behandlungskammer beträgt während der Behandlung weniger als 50 mbar. Mit einer derartigen Anlage können dünne Schichten von bis zu 1 oder 2 µm Dicke auf Substrate von bis zu 0.01 m² Fläche aufgebracht werden. Für grössere Substrate oder zum Aufbringen dickerer Schichten ist die in EP 0 297 637 A1 beschriebene Anlage nicht geeignet, da die Auftragsrate hierzu zu gering ist.

Aufgabe der Erfindung ist es, ein Verfahren und eine Beschichtungsanlage zum Beschichten und/oder zur Oberflächenbehandlung von Substraten mittels eines Plasmastrahls zur Verfügung zu stellen, mit denen reaktiv hergestellte Schichten von beispielsweise 2 µm Dicke oder auf vergleichsweise grosse Substratflächen von beispielsweise 0.05 m² oder grösser aufgebracht werden können sowie bedarfsweise dickere Schichten von beispielsweise 50 µm Dicke oder mehr. Eine weitere Aufgabe besteht darin, Substrate oder Werkstücke, die mit einem derartigen Verfahren hergestellt wurden, zur Verfügung zu stellen.

Diese Aufgabe wird erfindungsgemäss durch das in Anspruch 1 definierte Verfahren, das in Anspruch 10 definierte Substrat oder Werkstück und die in Anspruch 13 definierte Plasmabeschichtungsanlage gelöst.

In dem erfindungsgemässe Verfahren zum Beschichten und/oder zur Oberflächenbehandlung von Substraten mittels eines Plasmastrahls wird eine Arbeitskammer mit einem Plasmabrenner zur Verfügung gestellt, ein Plasmastrahl erzeugt, indem ein Plasmagas durch den Plasmabrenner geleitet und in demselben mittels elektrischer Gasentladung und/oder elektromagnetischer Induktion und/oder Mikrowellen aufgeheizt wird, und der Plasmastrahl auf ein in die Arbeitskammer eingebrachtes Substrat gelenkt. Das Verfahren zeichnet sich dadurch aus, dass der zur Verfügung gestellte Plasmabrenner eine Leistung zum thermischen Plasmaspritzen von Feststoffpartikeln aufweist, der Druck in der Arbeitskammer während des Verfahrens zwischen 0.01 und 10 mbar beträgt, mindestens eine reaktive Komponente in flüssiger oder gasförmiger Form in den Plasmastrahl injiziert wird, um eine Oberfläche des Substrats zu beschichten und/oder zu behandeln, und eine Schicht oder Beschichtung hergestellt und/oder eine Substratoberfläche behandelt wird, und die derart hergestellte Schicht oder Beschichtung oder die derart behandelte Substratoberfläche jeweils eine Dicke von 0.01 µm bis 10 µm aufweisen.

Vorteilhafterweise weist der Plasmabrenner eine maximale Leistung von 10 kW bis 200 kW oder 20 kW bis 100 kW auf, oder die maximale Leistung des Plasmabrenners beträgt mindestens 30 kW oder mindestens 50 kW oder mindestens 70 kW und/oder liegt zwischen 20 kW und 150kW. In der Praxis wird deshalb normalerweise ein Plasmabrenner zum thermischen Plasmaspritzen von Feststoffpartikeln verwendet. Weiter kann der Druck in der Arbeitskammer während des Verfahrens beispielsweise zwischen 0.02 mbar und 5 mbar oder zwischen 0.05 mbar und 2 mbar betragen. Fallweise wird die reaktive Komponente im Plasmabrenner in den Plasmastrahl injiziert und/oder in den freien Plasmastrahl. In einer vorteilhaften Ausführungsvariante wird zusätzlich Beschichtungsmaterial in Form von pulverartigen Feststoffpartikeln oder in Form einer Suspension in den Plasmastrahl eingebracht. In einer weiteren vorteilhaften Ausführungsvariante weisen die mittels des oben beschriebenen Verfahrens oder der oben beschriebenen Ausführungsvarianten hergestellte Schicht oder Beschichtung oder die derart behandelte Substratoberfläche eine Porosität von 0.01 % bis 5 % oder 0.02 % bis 2 % auf.

Mittels einer speziellen Ausführungsform des Verfahrens lassen sich Beschichtung mit mindestens zwei Schichten unterschiedlicher Struktur aufbringen, wobei mindestens eine der Schichten unter Verwendung des oben stehenden Verfahrens, im Folgenden auch als Dünnschichtverfahren bezeichnet, oder der oben stehenden Ausführungsvarianten hergestellt wird und mindestens eine weitere Schicht mittels thermischen Plasmaspritzens von Feststoffpartikeln, wobei beide Schichten mit demselben Plasmabrenner aufgebracht werden.

Vorteilhafterweise beträgt der Druck in der Arbeitskammer während des thermischen Plasmaspritzens zwischen 0.3 mbar bis 1 bar oder 0.5 mbar bis 500 mbar oder 1 mbar bis 200 mbar. Die mindestens eine Schicht, die mittels thermischen Plasmaspritzens aufgebracht wird, kann beispielsweise eine Dicke von 1 µm bis 2000 µm oder 10 µm bis 1000 µm aufweisen.

Weiter umfasst die Erfindung ein Substrat oder Werkstück mit mindestens einer Schicht hergestellt mit dem oben beschriebenen Dünnschichtverfahren oder den oben beschriebenen Ausführungsvarianten oder mit mindestens zwei Schichten unterschiedlicher Struktur hergestellt mit der oben beschriebenen speziellen Ausführungsform des Verfahrens. Im letzteren Fall kann das Substrat oder Werkstück beispielsweise mindestens eine Schicht, die mittels thermischen Plasmaspritzens von Feststoffpartikeln aufgebracht wurde, und mindestens eine Schicht hergestellt mit dem oben beschriebenen Dünnschichtverfahren oder den oben beschriebenen Ausführungsvarianten als Deckschicht umfassen. In einer vorteilhaften Ausführungsvariante enthält die mittels thermischen Plasmaspritzens von Feststoffpartikeln aufgebrachte Schicht eine oder mehrere oxidkeramische Komponenten oder besteht aus einer oder mehreren oxidkeramische Komponenten und/oder die mit dem oben beschriebenen Dünnschichtverfahren oder den oben beschriebenen Ausführungsvarianten hergestellte Schicht besteht im Wesentlichen aus SiOₓ.

Die erfindungsgemässe Plasmabeschichtungsanlage zum Beschichten und/oder zur Oberflächenbehandlung von Substraten umfasst eine Arbeitskammer mit einem Plasmabrenner zur Erzeugung eines Plasmastrahls, eine gesteuerte Pumpvorrichtung, die mit der Arbeitskammer verbunden ist, und einen Substrathalter zum Halten des Substrates, wobei der Plasmabrenner eine Leistung zum thermischen Plasmaspritzen von Feststoffpartikeln aufweist, der Druck in der Arbeitskammer mittels der gesteuerten Pumpvorrichtung auf einen Wert zwischen 0.01 mbar und 1 bar oder zwischen 0.02 mbar und 0.2 bar einstellbar ist, und wobei die Plasmabeschichtungsanlage zusätzlich eine Injektionsvorrichtung umfasst, um mindestens eine reaktive Komponente in flüssiger oder gasförmiger Form in den Plasmastrahl zu injizieren.

In einer vorteilhaften Ausführungsvariante umfasst die Plasmabeschichtungsanlage zusätzlich eine gesteuerte Verstellvorrichtung für den Plasmabrenner, um die Richtung des Plasmastrahls und/oder den Abstand des Plasmabrenners vom Substrat in einem Bereich von 0.2 m bis 2 m oder 0.3 m bis 1 m zu steuern. In einer weiteren vorteilhaften Ausführungsvariante ist der Plasmabrenner als DC-Plasmabrenner ausgebildet.

Das Verfahren und die Plasmabeschichtungsanlage gemäss vorliegender Erfindung haben den Vorteil, dass vergleichsweise grosse Substratflächen von beispielsweise 0.05 m² oder grösser mit reaktiv hergestellten Schichten versehen werden können, beispielsweise mit dünnen Schichten von 2 µm Dicke oder weniger, wobei die zu behandelnde und/oder zu beschichtende Substratfläche aus mehreren kleineren Substratflächen zusammengesetzt sein kann. Zusätzlich ist es auch möglich, längere Folien oder Substrate von beispielsweise 2 m Länge und mehr in einem quasi-kontinuierlichen Verfahren, zum Beispiel in einem "roll to roll"-Verfahren, zu behandeln und/oder zu beschichten. Mit dem erfindungsgemässen Verfahren lassen sich hochwertige dünne Schichten herstellen, die beispielsweise vergleichsweise homogen bezüglich Dicke und/oder Zusammensetzung sind und/oder zum Beispiel eine Porosität von 0.01 % bis 5 % oder 0.02 % bis 2 % aufweisen. Bedarfsweise lassen sich mittels eines thermischen Plasmaspritzverfahrens für Feststoffpartikel auch dickere Schichten von beispielsweise 50 µm Dicke oder mehr herstellen. Das hat den Vorteil, dass in derselben Plasmabeschichtungsanlage Beschichtungen aufgebracht werden können, die sowohl reaktiv hergestellte dünne Schichten als auch dickere Schichten enthalten, wobei die Schichten unmittelbar nacheinander aufgebracht werden können.

Die obige Beschreibung von Ausführungsformen und -varianten dient lediglich als Beispiel. Weitere vorteilhafte Ausführungsformen gehen aus den abhängigen Ansprüchen und der Zeichnung hervor. Darüber hinaus können im Rahmen der vorliegenden Erfindung auch einzelne Merkmale aus den beschriebenen oder gezeigten Ausführungsformen und -varianten miteinander kombiniert werden, um neue Ausführungsformen zu bilden.

Im Folgenden wird die Erfindung an Hand der Ausführungsbeispiele und an Hand der Zeichnung näher erläutert. Es zeigen:
- Fig. 1: ein Ausführungsbeispiel einer Plasmabeschichtungsanlage gemäss vorliegender Erfindung,
- Fig. 2: Ausführungsvarianten für die Injektion einer reaktiven Komponente in flüssiger oder gasförmiger Form in einen Plasmastrahl, und
- Fig. 3A,B,C: drei Ausführungsbeispiele von Substratbeschichtungen hergestellt mit einem Verfahren gemäss vorliegender Erfindung.

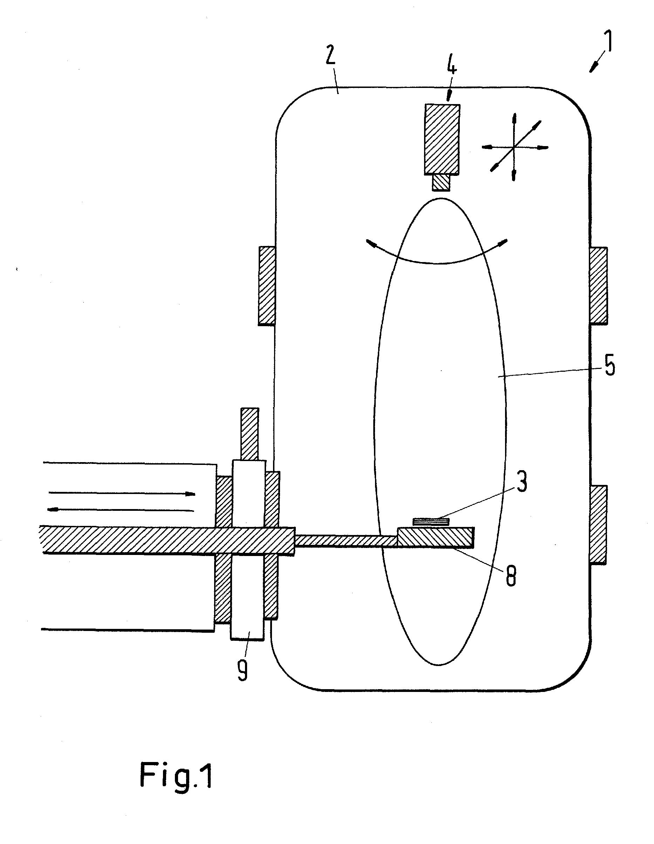

Fig. 1 zeigt ein Ausführungsbeispiel einer Plasmabeschichtungsanlage zum Beschichten und/oder zur Oberflächenbehandlung von Substraten gemäss vorliegender Erfindung. Die Plasmabeschichtungsanlage 1 umfasst eine Arbeitskammer 2 mit einem Plasmabrenner 4 zur Erzeugung eines Plasmastrahls 5, eine gesteuerte Pumpvorrichtung, die in Fig. 1 nicht gezeigt ist, und die mit der Arbeitskammer 2 verbunden ist, um den Druck in der Arbeitskammer einzustellen und einen Substrathalter 8 zum Halten des Substrates 3, wobei der Plasmabrenner 4 eine Leistung zum thermischen Plasmaspritzen von Feststoffpartikeln aufweist, der Druck in der Arbeitskammer 2 mittels der gesteuerten Pumpvorrichtung auf einen Wert zwischen 0.01 mbar und 1 bar oder zwischen 0.02 mbar und 0.2 bar einstellbar ist, und wobei die Plasmabeschichtungsanlage 1 zusätzlich eine Injektionsvorrichtung 6.1 - 6.3 umfasst, um mindestens eine reaktive Komponente in flüssiger oder gasförmiger Form in den Plasmastrahl 5 zu injizieren. Vorteilhafterweise ist der Plasmabrenner 4 als DC-Plasmabrenner ausgebildet.

Bei Bedarf kann der Substrathalter 8 als verschiebbarer Stabhalter ausgeführt sein, um das Substrat aus einer Vorkammer durch eine Dichtungsschleuse 9 in die Arbeitskammer 2 zu bewegen. Der Stabhalter ermöglicht zusätzlich, das Substrat falls erforderlich während der Behandlung und/oder Beschichtung zu drehen.

Vorteilhafterweise weist der Plasmabrenner eine maximale Leistung von 10 kW bis 200 kW, insbesondere 20 kW bis 100 kW auf, oder die maximale Leistung beträgt mindestens 30 kW oder mindestens 50 kW oder mindestens 70 kW. In der Praxis wird deshalb normalerweise ein Plasmabrenner zum thermischen Plasmaspritzen von Feststoffpartikeln verwendet. Typischerweise ist der Plasmabrenner mit einer Stromversorgung, zum Beispiel einer Gleichstromversorgung für einen DC-Plasmabrenner, und/oder mit einer Kühlvorrichtung und/oder mit einer Plasmagasversorgung verbunden und fallweise mit einer Versorgung für flüssige und/oder gasförmige reaktive Komponenten und/oder einer Fördervorrichtung für Spritzpulver oder Suspensionen.

Ein herkömmlicher Plasmabrenner mit einer Leistung zum thermischen Spritzen beziehungsweise ein herkömmlicher Plasmabrenner zum thermischen Spritzen kann beispielsweise eine Anoden und eine Kathode umfassen, um eine elektrische Entladung zu erzeugen, wobei in dem zum thermischen Spritzen notwendigen Leistungsbereich die Anode und Kathode normalerweise gekühlt werden, beispielsweise mittels Kühlwasser. Ein dem Plasmabrenner zugeführtes Prozessgas, auch Plasmagas genannt, wird in der elektrischen Entladung ionisiert, um einen Plasmastrahl mit einer Temperatur von bis zu 20'000 K zu erzeugen. Auf Grund der Wärmeausdehnung der Gase beziehungsweise des Plasmas verlässt der Plasmastrahl den Plasmabrenner mit einer Geschwindigkeit von typisch 200 m/s bis 4000 m/s. Das Prozess- oder Plasmagas kann beispielsweise Argon, Stickstoff, Helium und/oder Wasserstoff oder eine Mischung eines Edelgases mit Stickstoff und/oder Wasserstoff enthalten beziehungsweise aus einem oder mehreren dieser Gase bestehen.

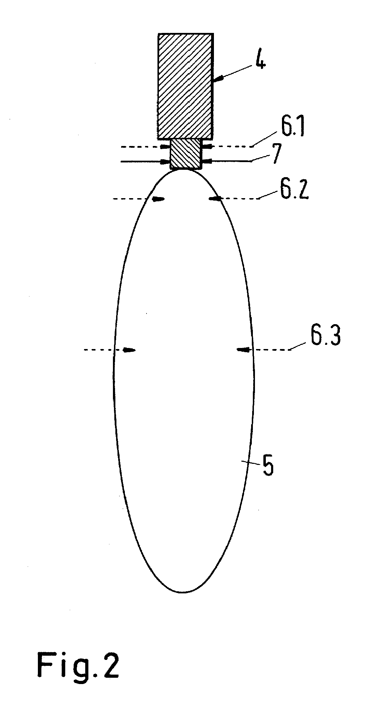

Fig. 2 zeigt drei Ausführungsvarianten für die Injektion einer reaktiven Komponente in flüssiger oder gasförmiger Form in einen Plasmastrahl 5. Der Plasmastrahl 5 wird, wie in Fig. 2 gezeigt, in einem Plasmabrenner 4 erzeugt. Je nach Ausführungsvariante ist ein Injektor 6.1 im Plasmabrenner vorgesehen, um eine reaktive Komponente in den Plasmastrahl zu injizieren. Der Injektor 6.1 kann beispielsweise im Bereich einer Düse angeordnet sein, die zum Formen des Plasmastrahls im Plasmabrenner vorgesehen ist. Die reaktive Komponente kann jedoch auch mittels eines Injektors 6.2, 6.3 in den freien Plasmastrahl injiziert werden, beispielsweise mittels eines Injektors 6.2, der in einem Abstand von wenigen cm von der Düsenaustrittsöffnung des Plasmabrenners angeordnet ist oder mittels eines Injektors 6.3, der in einem Abstand von 0.1 m bis 0.6 m vom Plasmabrenner angeordnet ist. Solange der Plasmastrahl noch wenig aufgefächert ist, wird der Injektor vorteilhafterweise im Wesentlichen mittig im Plasmastrahl angeordnet. Ist der Plasmastrahl stärker aufgefächert, beispielsweise in einem Abstand von typisch grösser 0.1 m vom Plasmabrenner, können beispielsweise auch ringförmige Injektoren verwendet werden.

In einer weiteren vorteilhaften Ausführungsvariante umfasst die Plasmabeschichtungsanlage 1 zusätzlich eine gesteuerte Verstellvorrichtung für den Plasmabrenner 4, die in Fig. 1 nicht gezeigt ist, um die Richtung des Plasmastrahls und/oder den Abstand des Plasmabrenners vom Substrat 3 zu steuern, beispielsweise in einem Bereich von 0.2 m bis 2 m oder 0.3 m bis 1 m. Fallweise können in der Verstellvorrichtung eine oder mehrere Schwenkachsen in unterschiedlicher Richtung vorgesehen sein. Darüber hinaus kann die Verstellvorrichtung auch eine oder zwei zusätzliche lineare Verstellachsen umfassen, um den Plasmabrenner 4 über unterschiedlichen Bereichen des Substrats 3 anzuordnen. Lineare Bewegungen und Schwenkbewegungen des Plasmabrenners erlauben eine Steuerung der Substratbehandlung und -beschichtung, beispielsweise um ein Substrat über die gesamte Fläche gleichmässig vorzuheizen, oder um auf der Substratoberfläche eine gleichmässige Schichtdicke und/oder Schichtqualität zu erzielen.

In einer vorteilhaften Ausführungsform ist der Plasmabrenner 4 mit einer oder mehreren Zuführungen 7 versehen, um Beschichtungsmaterial in Form von pulverartigen Feststoffpartikeln und/oder in Form einer Suspension zu zuführen und Schichten mittels thermischen Plasmaspritzens aufzubringen.

Die Zuführung oder Zuführungen 7 können zum Beispiel bis in den Bereich einer Düse geführt sein, die zum Formen des Plasmastrahls im Plasmabrenner vorgesehen ist, um an dieser Stelle pulverartige Feststoffpartikel und/oder Suspensionen in den Plasmastrahl 5 einzubringen. Die pulverartigen Feststoffpartikel werden normalerweise mittels eines Fördergases zugeführt.

Ein Ausführungsbeispiel des erfindungsgemässen Verfahrens zum Beschichten und/oder zur Oberflächenbehandlung von Substraten mittels eines Plasmastrahls wird im Folgenden an Hand der Figuren 1, 2 und 3A - C beschrieben. In dem Verfahren wird eine Arbeitskammer 2 mit einem Plasmabrenner 4 zur Verfügung gestellt, ein Plasmastrahl 5 erzeugt, indem ein Plasmagas durch den Plasmabrenner geleitet und in demselben mittels elektrischer Gasentladung und/oder elektromagnetischer Induktion und/oder Mikrowellen aufgeheizt wird, und der Plasmastrahl 5 auf ein in die Arbeitskammer 2 eingebrachtes Substrat 3 gelenkt. Das Verfahren zeichnet sich dadurch aus, dass der zur Verfügung gestellte Plasmabrenner 4 eine Leistung zum thermischen Plasmaspritzen von Feststoffpartikeln aufweist, der Druck in der Arbeitskammer 2 während des Verfahrens zwischen 0.01 und 10 mbar beträgt, mindestens eine reaktive Komponente in flüssiger oder gasförmiger Form in den Plasmastrahl 5 injiziert wird, um eine Oberfläche des Substrats zu beschichten und/oder zu behandeln, und eine Schicht 11, 11' oder Beschichtung 10 hergestellt und/oder eine Substratoberfläche behandelt wird, und die derart hergestellte Schicht oder Beschichtung oder die derart behandelte Substratoberfläche jeweils eine Dicke von 0.01 µm bis 10 µm aufweisen.

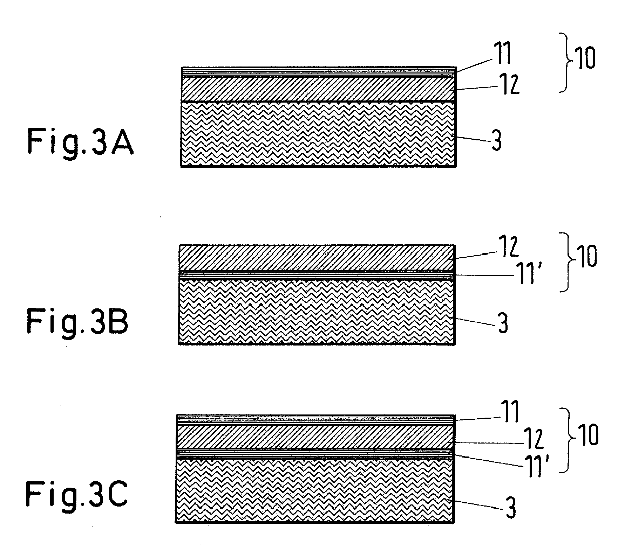

Mögliche Behandlungen der Oberfläche des Substrats 3 umfassen beispielsweise das Aufheizen, Reinigen, Ätzen, Oxidieren oder Nitrieren mittels Plasmastrahl. Einige Ausführungsbeispiele von Beschichtungen, die unter Verwendung des oben beschriebenen Verfahrens hergestellten wurden, sind nachstehend im Rahmen der Beschreibung der Figuren 3A - C näher erläutert.

Vorteilhafterweise weist der Plasmabrenner 4 eine maximale Leistung von 10 kW bis 200 kW, insbesondere 20 kW bis 150 kW oder 20 kW bis 100 kW auf, oder die maximale Leistung beträgt mindestens 30 kW oder mindestens 50 kW oder mindestens 70 kW. Weiter kann der Druck in der Arbeitskammer 2 während des Verfahrens beispielsweise zwischen 0.02 mbar und 5 mbar oder zwischen 0.05 mbar und 2 mbar betragen. Fallweise wird die reaktive Komponente im Plasmabrenner in den Plasmastrahl injiziert und/oder in den freien Plasmastrahl. Fig. 2 zeigt drei Ausführungsvarianten für die Injektion einer reaktiven Komponente in flüssiger oder gasförmiger Form in den Plasmastrahl 5. Die drei Ausführungsvarianten wurden bereits im Rahmen der oben stehenden Beschreibung der Plasmabeschichtungsanlage näher erläutert.

Bedarfsweise kann der Plasmastrahl 5 während dem Behandeln oder Beschichten über die Oberfläche des Substrats geschwenkt werden, um eine gleichmässige Behandlung oder Beschichtung zu erzielen, und um mögliche lokale Erwärmungen und/oder Beschädigungen der Substratoberfläche beziehungsweise des Substrates zu vermeiden, die bei einem konstant ausgerichteten Plasmastrahl bei hoher Strahlleistung entstehen können.

In einer vorteilhaften Ausführungsvariante wird zusätzlich Beschichtungsmaterial in Form von pulverartigen Feststoffpartikeln oder in Form einer Suspension in den Plasmastrahl 5 eingebracht. In einer weiteren vorteilhaften Ausführungsvariante weisen die unter Verwendung des oben beschriebenen Verfahrens oder der oben beschriebenen Ausführungsvarianten hergestellte Schicht 11, 11' oder Beschichtung 10 oder die derart behandelte Substratoberfläche eine Porosität von 0.01 % bis 5 % oder 0.02 % bis 2 % auf.

Mittels einer speziellen Ausführungsform des Verfahrens lassen sich Beschichtung mit mindestens zwei Schichten unterschiedlicher Struktur aufbringen, wobei mindestens eine der Schichten unter Verwendung des oben stehenden Verfahrens, im Folgenden auch als Dünnschichtverfahren bezeichnet, oder der oben stehenden Ausführungsvarianten hergestellt wird und mindestens eine weitere Schicht mittels thermischen Plasmaspritzens von Feststoffpartikeln, wobei beide Schichten mit demselben Plasmabrenner 4 aufgebracht werden.

Vorteilhafterweise beträgt der Druck in der Arbeitskammer 2 während des thermischen Plasmaspritzens zwischen 0.3 mbar bis 1 bar oder 0.5 mbar bis 500 mbar oder 1 mbar bis 200 mbar. Die mindestens eine Schicht, die mittels thermischen Plasmaspritzens aufgebracht wird, kann beispielsweise eine Dicke von 1 µm bis 2000 µm oder 10 µm bis 1000 µm aufweisen.

Weiter umfasst die Erfindung ein Substrat 3 oder Werkstück mit mindestens einer Schicht hergestellt mit dem oben beschriebenen Dünnschichtverfahren oder den oben beschriebenen Ausführungsvarianten oder mit mindestens zwei Schichten unterschiedlicher Struktur hergestellt mit der oben beschriebenen speziellen Ausführungsform des Verfahrens. Im letzteren Fall kann das Substrat oder Werkstück beispielsweise mindestens eine Schicht, die mittels thermischen Plasmaspritzens von Feststoffpartikeln aufgebracht wurde, und mindestens eine Schicht hergestellt mit dem oben beschriebenen Dünnschichtverfahren oder den oben beschriebenen Ausführungsvarianten als Deckschicht umfassen. In einer vorteilhaften Ausführungsvariante enthält die mittels thermischen Plasmaspritzens von Feststoffpartikeln aufgebrachte Schicht eine oder mehrere oxidkeramische Komponenten, wie beispielsweise Al₂O₃, TiO₂, Cr₂O₃, ZrO₂, Y₂O₃ oder Al-Mg-Spinell, oder besteht aus einer oder mehreren oxidkeramische Komponenten und/oder die mit dem oben beschriebenen Dünnschichtverfahren oder den oben beschriebenen Ausführungsvarianten hergestellte Schicht besteht im Wesentlichen aus SiOₓ.

Typische Anwendungen von Substraten mit mindestens zwei Schichten unterschiedlicher Struktur, die mit der oben beschriebenen speziellen Ausführungsform des Verfahrens hergestellt wurden, umfassen beispielsweise:
- eine mittels thermischen Plasmaspritzens von Feststoffpartikeln aufgebrachte Schicht aus Al₂O₃ oder Al-Mg-Spinell als elektrische und/oder thermische Isolationsschicht und eine mit dem oben beschriebenen Dünnschichtverfahren aufgebrachte Deckschicht aus SiOₓ als Versiegelung,
- eine mittels thermischen Plasmaspritzens von Feststoffpartikeln aufgebrachte Schicht aus TiO₂, Al₂O₃/,TiO₂ oder Cr₂O₃ als optische Absorptionsschicht, zum Beispiel zur Verbesserung des Wirkungsgrades solarthermischer Komponenten, und eine mit dem oben beschriebenen Dünnschichtverfahren aufgebrachte Deckschicht aus SiOₓ als Schutz gegen Rückreflexion, oder
- eine mittels thermischen Plasmaspritzens von Feststoffpartikeln aufgebrachte Schicht aus ZrO₂ und/oder Y₂O₃ für elektronische Anwendungen und/oder als thermische Isolationsschicht und eine mit dem oben beschriebenen Dünnschichtverfahren aufgebrachte Deckschicht aus ZrO₂ oder SiOₓ als Versiegelung.

Die Figuren 3A - C zeigen drei Ausführungsbeispiele von Substratbeschichtungen 10, die unter Verwendung der oben beschriebenen speziellen Ausführungsform des Verfahrens hergestellt wurden. In dem in Fig. 3A gezeigten Ausführungsbeispiel wurde ein Substrat 3 zuerst mittels thermischen Plasmaspritzens mit einer Schicht 12 von typisch 2 µm bis 1000 µm Dicke versehen und anschliessend mittels eines reaktiven thermischen Niederdruckplasmas eine 0.1 µm bis 1 µm dicke Deckschicht 11 aufgebracht. In dem in Fig. 3B gezeigten Ausführungsbeispiel wurde ein Substrat 3 zuerst mittels eines reaktiven thermischen Niederdruckplasmas mit einer Schicht 11' von typisch 0.1 µm bis 1 µm Dicke versehen, die beispielsweise als Haftschicht oder Diffusionssperrschicht ausgebildet sein kann, und anschliessend mittels thermischen Plasmaspritzens eine Schicht 12 von typisch 2 µm bis 1000 µm Dicke aufgebracht. Im dritten Ausführungsbeispiel, das in Fig. 3C gezeigt ist, wurde ein Substrat 3 mittels eines reaktiven thermischen Niederdruckplasmas mit einer ersten Schicht 11' von typisch 0.1 µm bis 1 µm Dicke und mittels thermischen Plasmaspritzens mit einer zweiten Schicht 12 von typisch 2 µm bis 1000 µm Dicke versehen, und anschliessend mittels eines reaktiven thermischen Niederdruckplasmas eine 0.1 µm bis 1 µm dicke Deckschicht 11 aufgebracht.

Im folgenden Ausführungsbeispiel des erfindungsgemässen Verfahrens wird die Herstellung und Anwendung einer dünnen SiOₓ Schicht mittels eines reaktiven thermischen Niederdruckplasmas näher erläutert. Zur Herstellung kann ein handelsüblicher Plasmabrenner mit einer Leistung zum thermischen Plasmaspritzen verwendet werden, beispielsweise ein Plasmabrenner mit drei Kathoden und kaskadierter Anode, der mit einer Wasserkühlung ausgestattet ist. Als Plasmagas kann eine Mischung von Argon und Wasserstoff oder Argon und Helium verwendet werden, und die reaktive Komponente, die in den Plasmastrahl injiziert wird, kann zum Beispiel aus einer Mischung von gasförmigem Hexamethyldisiloxan (HMDSO) mit Sauerstoff bestehen. Typisch beträgt der Sauerstoffanteil in der HMDSO/O₂-Mischung rund 2 % bis 3 % bezogen auf den Gasfluss. Um eine hohe Gasausbeute zu erzielen, wird die reaktive Komponente normalerweise in vergleichsweise geringem Abstand von der Substratoberfläche in den Plasmastrahl injiziert, beispielsweise mittels eines ringförmigen Injektors, der in einem Abstand von einigen cm von der Substratoberfläche angeordnet ist. Der Abstand des Plasmabrenners vom Substrat kann beispielsweise 0.3 m bis 0.6 m betragen, der Druck in der Arbeitskammer 0.2 mbar bis 1 mbar und die dem Plasmabrenner zugeführte Leistung 8 kW bis 16 kW.

Auf diese Weise können hochwertige SiOₓ-Schichten bis 2 µm Dicke aufgebracht werden. Die Abscheidrate auf einem 30 cm x 30 cm grossen Substrat liegt typisch bei 10 nm/s oder höher, wobei bezogen auf das zugeführte HMDSO-Gas eine hohe Gasausbeute erreicht werden kann. SiOₓ-Schichten von typisch 0.1 µm Dicke oder weniger werden beispielsweise in der Verpackungsindustrie als Diffusionssperrschicht gegen Wasserdampf und Sauerstoff verwendet. Darüber hinaus bestehen Anwendungen für derartige Schichten in der Textilindustrie.

In einem weiteren Ausführungsbeispiel des erfindungsgemässen Verfahrens wird die Herstellung einer elektrisch isolierenden Beschichtung näher erläutert. Der Aufbau der Beschichtung entspricht dem in Fig. 3A gezeigten Ausführungsbeispiel, d.h. ein zu beschichtendes Substrat 3 wird zuerst mittels thermischen Plasmaspritzens mit einer Al₂O₃-Schicht 12 von typisch 20 µm bis 40 µm Dicke versehen und anschliessend mittels eines reaktiven thermischen Niederdruckplasmas eine 0.1 µm bis 0.2 µm dicke Deckschicht 11 aus SiOₓ aufgebracht. Bei Bedarf wird die Substratoberfläche vor dem Beschichten gereinigt, um die Haftung der Beschichtung zu erhöhen. Im vorliegenden Ausführungsbeispiel wird die zu beschichtende Oberfläche beispielsweise zuerst mit Alkohol gereinigt und anschliessend mit feinem Pulver sandgestrahlt.

Für die Herstellung der Beschichtung 10 kann beispielsweise ein handelsüblicher Plasmabrenner zum thermischen Plasmaspritzen verwendet werden. Als Plasmagas wird in diesem Ausführungsbeispiel eine Mischung von Argon mit 4 % bis 10 % Wasserstoff verwendet. Zum thermischen Plasmaspritzen der ersten Schicht 12 kann der Abstand des Plasmabrenners 4 vom Substrat 3 beispielsweise 0.8 m bis 1.2 m betragen und der Druck in der Arbeitskammer 0.5 mbar bis 2 mbar. Dies ergibt einen vergleichsweise breiten Plasmastrahl, mit dem auch grössere Substrate von 0.05 m² und grösser beschichtet werden können. Die dem Plasmabrenner zum thermischen Plasmaspritzen zugeführte Leistung beträgt typisch 60 kW bis 100 kW, wobei der Plasmabrenner wassergekühlt ist, so dass ein Teil der Leistung ans Kühlwasser abgegeben wird.

Vor dem Beschichten wird das Substrat 3 normalerweise vorgeheizt, um die Haftung der ersten Schicht 12 auf dem Substrat zu verbessern. Das Vorheizen des Substrats kann mit denselben Plasmaparametern erfolgen, wie das Aufbringen der ersten Schicht, wobei es normalerweise genügt, den Plasmastrahl 5, der zum Vorheizen weder Beschichtungspulver noch reaktive Komponenten enthält, mit einigen Schwenkbewegungen über das Substrat zu führen. Typisch reichen 20 bis 30 Schwenkbewegungen aus, um die Substratoberfläche auf eine Temperatur von 200 °C bis 500 °C zu erwärmen.

Je nach Art und Menge des zu schmelzenden Beschichtungspulvers kann dieses durch eine oder mehrere Zuführungen im Plasmabrenner 4 zugeführt werden, wo die Enthalpie grösser ist, oder das Beschichtungspulver kann ausserhalb desselben in den Plasmastrahl 5 injiziert werden. Im vorliegenden Ausführungsbeispiel wird das Al₂O₃-Pulver zum Beispiel über zwei bezüglich des Plasmastrahls gegenüberliegende Zuführungen im Plasmabrenner zugeführt. Als Fördergas für das Al₂O₃-Pulver kann beispielsweise Argon verwendet werden. Nach dem Vorheizen der Substratoberfläche wird mit dem Aufbringen der ersten Schicht begonnen, wobei der Plasmastrahl 5, der das aufgeschmolzene Beschichtungspulver enthält, mittels Schwenkbewegungen über das Substrat 3 geführt wird. Fallweise kann zusätzlich oder an Stelle des Schwenkens des Plasmastrahls das Substrat mittels des Stabhalters 8 bewegt werden. Mit rund 100 bis 200 Schwenkbewegungen des Plasmastrahls kann innerhalb von 2 bis 5 min. eine 20 µm bis 40 µm dicke Al₂O₃-Schicht aufgebracht werden.

In einem weiteren Schritt wird, wie im Rahmen des vorangehenden Ausführungsbeispiels beschrieben, mittels eines reaktiven thermischen Niederdruckplasmas eine 0.1 µm bis 0.2 µm dicke SiOₓ-Schicht 11 aufgebracht. Dazu werden die Plasmaparameter entsprechend dem vorangehenden Ausführungsbeispiel angepasst und eine Mischung von gasförmigem Hexamethyldisiloxan (HMDSO) mit Sauerstoff in vergleichsweise geringem Abstand von der Substratoberfläche in den Plasmastrahl 5 injiziert. Die Zuführung für das Beschichtungspulver bleibt während des Aufbringens der SiOₓ-Schicht unterbrochen. Nach dem Aufbringen der SiOₓ-Schicht ist die isolierende Beschichtung 10 vollständig.

Falls das Substrat 3 auf einem Stabhalter 8 befestigt ist, kann dasselbe aus der Arbeitskammer 2 zum Abkühlen in eine Vorkammer zurückgezogen werden. Die Vorkammer ist zweckmässigerweise mit Argon gefüllt, wobei die Abkühlzeit und der Druck in der Vorkammer der Art des Substrats und der Art der Beschichtung angepasst werden können. Eine Abkühlzeit von 10 min. bei einem Druck von 0.5 bar in Argon ist normalerweise genügend, um innere Spannungen und Risse während dem Abkühlen zu vermeiden.

Elektrische Isolationsschichten, wie beispielsweise Al₂O₃-Schichten, die mittels thermischen Spritzens aufgebracht werden, sind bedingt durch das verwendete Beschichtungsverfahren nie vollständig dicht und isolierend. Die oben beschriebene Beschichtung mit einer mittels eines thermischen Plasmaspritzverfahrens aufgebrachten Al₂O₃-Schicht und einer mittels eines reaktiven thermischen Niederdruckplasmas hergestellten SiOₓ-Deckschicht hat den Vorteil, dass Dank der Deckschicht die Aufnahme von Wasser verringert wird, und dass wesentlich bessere Isolationseigenschaften erzielt werden können.

Die oben beschriebene Plasmabeschichtungsanlage und das oben beschriebene Verfahren sowie die zugehörigen Ausführungsvarianten erlauben die reaktive Herstellung hochwertiger dünner Schichten auf vergleichsweise grossen Substratflächen von beispielsweise 0.05 m² oder grösser sowie bedarfsweise die Herstellung dickerer Schichten von beispielsweise 50 µm Dicke oder mehr und ermöglichen damit den industriellen Einsatz derartiger Schichten.

## Patentansprüche

1. Verfahren zum Beschichten und/oder zur Oberflächenbehandlung von Substraten mittels eines Plasmastrahls, wobei
- eine Arbeitskammer (2) mit einem Plasmabrenner (4) zur Verfügung gestellt wird,
- ein Plasmastrahl (5) erzeugt wird, indem ein Plasmagas durch den Plasmabrenner (4) geleitet und in demselben mittels elektrischer Gasentladung und/oder elektromagnetischer Induktion und/oder Mikrowellen aufgeheizt wird, und
- der Plasmastrahl (5) auf ein in die Arbeitskammer eingebrachtes Substrat (3) gelenkt wird,
**dadurch gekennzeichnet, dass**
- der zur Verfügung gestellte Plasmabrenner (4) eine Leistung zum thermischen Plasmaspritzen von Feststoffpartikeln aufweist,
- der Druck in der Arbeitskammer (2) während des Verfahrens zwischen 0.01 und 10 mbar beträgt,
- mindestens eine reaktive Komponente in flüssiger oder gasförmiger Form in den Plasmastrahl (5) injiziert wird, um eine Oberfläche des Substrats (3) zu beschichten und/oder zu behandeln, und
- eine Schicht (11, 11') oder Beschichtung (10) hergestellt und/oder eine Substratoberfläche behandelt wird, und die derart hergestellte Schicht oder Beschichtung oder die derart behandelte Substratoberfläche jeweils eine Dicke von 0.01 µm bis 10 µm aufweisen.

2. Verfahren nach Anspruch 1, wobei der Plasmabrenner (4) eine maximale Leistung aufweist, die mindestens 30 kW oder mindestens 50 kW oder mindestens 70 kW beträgt und/oder zwischen 20 kW und 150kW liegt.

3. Verfahren nach einem der Ansprüche 1 oder 2, wobei der Druck in der Arbeitskammer (2) während des Verfahrens zwischen 0.02 mbar und 5 mbar, insbesondere zwischen 0.05 mbar und 2 mbar beträgt.

4. Verfahren nach einem der vorangehenden Ansprüche, wobei die reaktive Komponente im Plasmabrenner in den Plasmastrahl injiziert wird, und/oder wobei die reaktive Komponente in den freien Plasmastrahl (5) injiziert wird.

5. Verfahren nach einem der vorangehenden Ansprüche, wobei zusätzlich Beschichtungsmaterial in Form von pulverartigen Feststoffpartikeln oder in Form einer Suspension in den Plasmastrahl (5) eingebracht wird.

6. Verfahren nach einem der vorangehenden Ansprüche, wobei die derart hergestellte Schicht (11, 11') oder Beschichtung (10) oder die derart behandelte Substratoberfläche eine Porosität von 0.01 % bis 5 %, insbesondere von 0.02 % bis 2 % aufweisen.

7. Verfahren zur Herstellung von Beschichtungen (10) mit mindestens zwei Schichten (11, 11', 12) unterschiedlicher Struktur, **dadurch gekennzeichnet, dass** mindestens eine der Schichten (11, 11') unter Verwendung eines Verfahrens nach einem der vorangehenden Ansprüche hergestellt wird, und dass mindestens eine weitere Schichte (12) mittels thermischen Plasmaspritzens von Feststoffpartikeln aufgebracht wird, wobei beide Schichten mit demselben Plasmabrenner (4) aufgebracht werden.

8. Verfahren nach Anspruch 7, wobei der Druck in der Arbeitskammer (2) während des thermischen Plasmaspritzens zwischen 0.3 mbar bis 1 bar, insbesondere zwischen 0.5 mbar bis 500 mbar oder 1 mbar bis 200 mbar beträgt.

9. Verfahren nach einem der Ansprüche 7 oder 8, wobei die mindestens eine Schicht (12), die mittels thermischen Plasmaspritzens aufgebracht wird, eine Dicke von 2 µm bis 2000 µm, insbesondere von 10 µm bis 1000 µm aufweist.

10. Substrat oder Werkstück mit mindestens einer Schicht (11, 11') hergestellt mit einem Verfahren nach einem der Ansprüche 1 bis 6 oder mit mindestens zwei Schichten (11, 11', 12) unterschiedlicher Struktur hergestellt mit einem Verfahren nach einem der Ansprüche 7 bis 9.

11. Substrat oder Werkstück nach Anspruch 10 mit mindestens zwei Schichten (11, 11', 12) unterschiedlicher Struktur umfassend mindestens eine Schicht (12), die mittels thermischen Plasmaspritzens von Feststoffpartikeln aufgebracht wurde, und mindestens eine Schicht (11) hergestellt mit einem Verfahren nach einem der Ansprüche 1 bis 6 als Deckschicht.

12. Substrat oder Werkstück nach Anspruch 11, wobei die mittels thermischen Plasmaspritzens von Feststoffpartikeln aufgebrachte Schicht (12) eine oder mehrere oxidkeramische Komponenten enthält oder aus einer oder mehreren oxidkeramische Komponenten besteht, und wobei die mit einem Verfahren nach einem der Ansprüche 1 bis 6 hergestellte Schicht (11) im Wesentlichen aus SiOₓ besteht.

13. Plasmabeschichtungsanlage zum Beschichten und/oder zur Oberflächenbehandlung von Substraten umfassend eine Arbeitskammer (2) mit einem Plasmabrenner (4) zur Erzeugung eines Plasmastrahls (5), eine gesteuerte Pumpvorrichtung, die mit der Arbeitskammer verbunden ist, und einen Substrathalter (8) zum Halten des Substrates (3), **dadurch gekennzeichnet, dass** der Plasmabrenner (4) eine Leistung zum thermischen Plasmaspritzen von Feststoffpartikeln aufweist, dass der Druck in der Arbeitskammer (2) mittels der gesteuerten Pumpvorrichtung auf einen Wert zwischen 0.01 mbar und 1 bar, insbesondere zwischen 0.02 mbar und 0.2 bar einstellbar ist, und dass die Plasmabeschichtungsanlage (1) zusätzlich eine Injektionsvorrichtung (6.1 - 6.3) umfasst, um mindestens eine reaktive Komponente in flüssiger oder gasförmiger Form in den Plasmastrahl (5) zu injizieren.

14. Plasmabeschichtungsanlage nach Anspruch 13 umfassend zusätzlich eine gesteuerte Verstellvorrichtung für den Plasmabrenner (4), um die Richtung des Plasmastrahls (5) und/oder den Abstand des Plasmabrenners (4) vom Substrat (3) in einem Bereich von 0.2 m bis 2 m, insbesondere in einem Bereich von 0.3 m bis 1 m zu steuern.

15. Plasmabeschichtungsanlage nach Anspruch 13 oder 14, wobei der Plasmabrenner (4) als DC-Plasmabrenner ausgebildet ist.
